(19) Europäisches Patentamt
European Patent Office
Office européen des brevets

(11) EP 3 041 128 A1

(12) **EUROPEAN PATENT APPLICATION**
published in accordance with Art. 153(4) EPC

(43) Date of publication:
06.07.2016 Bulletin 2016/27

(51) Int Cl.:
*H02N 2/18* (2006.01)

(21) Application number: 14839011.5

(22) Date of filing: 17.07.2014

(86) International application number:
PCT/JP2014/003792

(87) International publication number:
WO 2015/029317 (05.03.2015 Gazette 2015/09)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 29.08.2013 JP 2013177635

(71) Applicant: Panasonic Intellectual Property
Management Co., Ltd.
Osaka-shi, Osaka 540-6207 (JP)

(72) Inventors:
• TAMURA, Masaya
Osaka-shi, Osaka 540-6207 (JP)
• KATSUMURA, Hidenori
Osaka-shi, Osaka 540-6207 (JP)

(74) Representative: Grünecker Patent- und
Rechtsanwälte
PartG mbB
Leopoldstraße 4
80802 München (DE)

(54) **ENVIRONMENTAL POWER GENERATION DEVICE**

(57) An energy-harvesting device includes a power generating element configured to generate electric power, a storage capacitor configured to store the electric power generated by the power generating element, a DC/DC converter configured to convert, into a predetermined voltage, a voltage obtained from the electric power generated by the power generating element and the electric power stored in the storage capacitor, a delay section for delaying a voltage corresponding to a voltage across the storage capacitor, and a controller configured to output an activating signal that activates the DC/DC converter when the delayed voltage is higher than a reference voltage. The energy-harvesting device thus can produce a necessary voltage and power.

FIG. 1

**Description**

TECHNICAL FIELD

The present invention relates to an energy-harvesting device using a power generating element.

BACKGROUND ART

An energy harvesting utilizing light energy, heat energy, or kinetic energy such as vibrations and a pressure for generating electric power has been paid in attention. Electronic devices driven by an energy-harvesting device that uses the foregoing power generation have been developed. These electronic devices include sensors or transmitters requiring no maintenance, such as replacing of batteries.

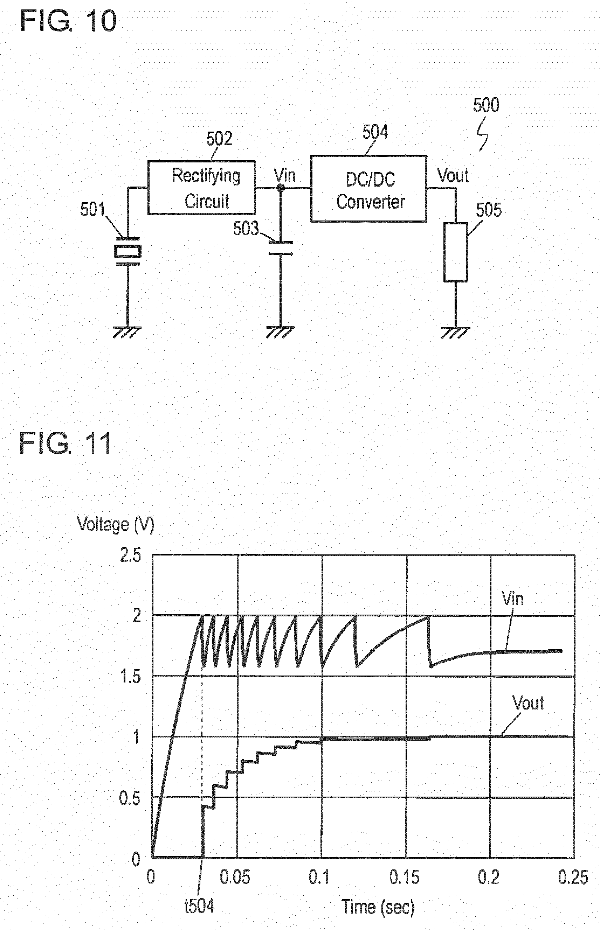

FIG. 10 is a block diagram of conventional energy-harvesting device 500. In the case that power generating element 501 used for the energy harvesting is an element that generates electric power due to vibration, power generating element 501 generates positive and negative electric charges alternately in response to the vibration, and generates an alternating-current (AC) current by taking out the electric charges. However, since the electric power generated by the energy harvesting is unstable and difficult to keep a constant level, the AC current is rectified and converted to a direct-current (DC) current by rectifying circuit 502, and then, the converted electric power is charged in storage capacitor 503. DC/DC converter 504 converts DC voltage Vin to predetermined DC voltage Vout. For instance, in the case that DC/DC converter 504 is a buck converter, DC/DC converter 504 converts DC voltage Vin into DC voltage lower than DC voltage Vin and outputs DC voltage Vout. In the case that DC/DC converter 504 is a boost converter, DC/DC converter 504 converts DC voltage Vin into DC voltage Vout higher than DC voltage Vin and outputs DC voltage Vout. The DC voltage Vout is then supplied to load 505.

FIG. 11 shows input voltage Vin and output voltage Vout of DC/DC converter 504. In FIG. 11, a vertical axis represents a voltage, and a lateral axis represents time. Conventional energy-harvesting device 500 may fail to boost voltage Vout enough to drive load 505. A conventional energy-harvesting device similar to energy-harvesting device 500 is disclosed in, for instance, PTL 1.

CITATION LIST

PATENT LITERATURE

PTL 1: Japanese Patent Laid-Open Publication No. 2012-80596

SUMMARY

An energy-harvesting device includes a power generating element configured to generate electric power, a storage capacitor configured to store the electric power generated by the power generating element, a DC/DC converter configured to convert, into a predetermined voltage, a voltage obtained from the electric power generated by the power generating element and the electric power stored in the storage capacitor, a delay section for delaying a voltage corresponding to a voltage across the storage capacitor, and a controller configured to output an activating signal that activates the DC/DC converter when the delayed voltage is higher than a reference voltage. This device activates the DC/DC converter after the storage capacitor is sufficiently charged, thereby providing a predetermined output voltage and power. The energy-harvesting device thus can produce a necessary voltage and power.

BRIEF DESCRIPTION OF DRAWINGS

FIG. 1 is a circuit diagram of an energy-harvesting device in accordance with Exemplary Embodiment 1.
FIG. 2 is a sectional view of a power generating element of the energy-harvesting device in accordance with Embodiment 1.
FIG. 3 shows a waveform of an output current of the power generating element in accordance with Embodiment 1.
FIG. 4 shows an input voltage of a DC/DC converter of the energy-harvesting device in accordance with Embodiment 1.
FIG. 5 shows an output voltage of the DC/DC converter of the energy-harvesting device in accordance with Embodiment 1.
FIG. 6 is a circuit diagram of another energy-harvesting device in accordance with Embodiment 1.

FIG. 7 shows an input voltage and an output voltage of the DC/DC converter of the energy-harvesting device shown in FIG. 6.

FIG. 8 is a circuit diagram of an energy-harvesting device in accordance with Exemplary Embodiment 2.

FIG. 9 is a circuit diagram of another energy-harvesting device in accordance with Embodiment 2.

FIG. 10 is a circuit diagram of a conventional energy-harvesting device.

FIG. 11 shows an input voltage and an output voltage of the conventional energy-harvesting device.

BRIEF DESCRIPTION OF PREFERRED EMBODIMENTS EXEMPLARY EMBODIMENT 1

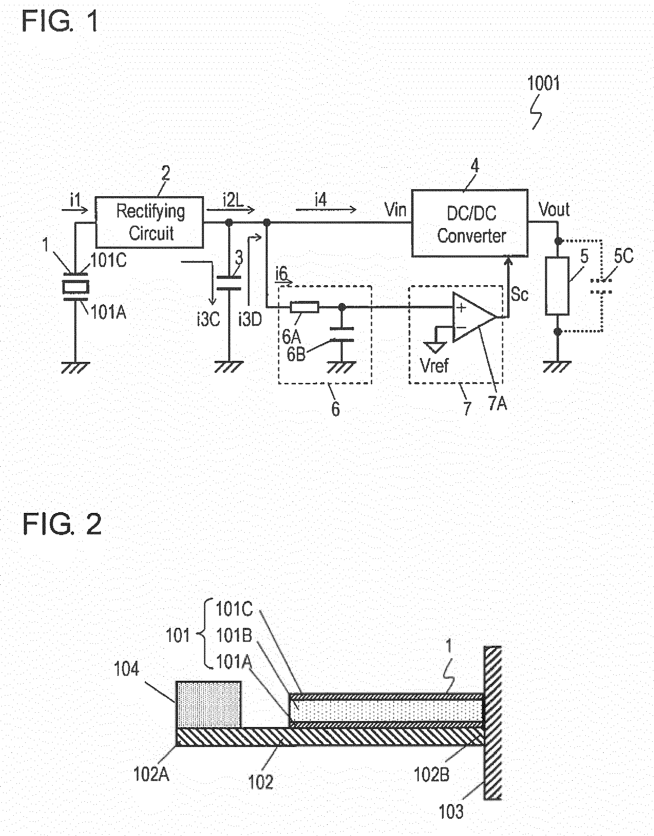

FIG. 1 is a circuit diagram of energy-harvesting device 1001 in accordance with Exemplary Embodiment 1. Energy-harvesting device 1001 includes power generating element 1 configures to generate electric power, rectifying circuit 2 connected to power generating element 1, storage capacitor 3 connected to rectifying circuit 2 configured to store direct-current (DC) power rectified by rectifying circuit 2, DC/DC converter 4 connected to rectifying circuit 2 and storage capacitor 3 and configured to convert DC voltage Vin rectified by rectifying circuit 2 to a predetermined DC voltage Vout, delay section 6 connected to rectifying circuit 2, storage capacitor 3, and an input terminal of DC/DC converter 4 configured to receive a voltage corresponding to a voltage of storage capacitor 3, and controller 7 configured to output, based on a voltage supplied from delay section 6, activating signal Sc which activates DC/DC converter 4.

The voltage across storage capacitor 3 is divided, and the divided voltage is applied to delay section 6. An output from DC/DC converter 4 is supplied to load 5.

Delay section 6 includes resistor 6A and delay capacitor 6B. Resistor 6A is connected in series to storage capacitor 3 and controller 7 and between storage capacitor 3 and controller 7. Delay capacitor 6B is connected between resistor 6A and the ground. To be more specific, resistor 6A has one end connected to storage capacitor 3 and another end connected to controller 7. Delay capacitor 6B is connected between the second end of resistor 6A and a ground.

FIG. 2 is a sectional view of an example of power generating element 1 to be used when a vibration power generation, an example of energy harvesting, is carried out. Power generating element 1 in accordance with Embodiment 1 is a piezoelectric power generating element made of piezoelectric material for generating electric power. Power generating element 1 includes elastic slip 102 connected to fixing section 103, and power generating section 101 disposed on elastic slip 2. Power generating section 101 includes lower electrode 101A disposed on elastic slip 102, piezoelectric layer 101B made of piezoelectric material, such as lead-zirconate-titanate (PZT) disposed on lower electrode 101A, and upper electrode 101C disposed on piezoelectric layer 101B. The piezoelectric material may be crystal, lithium tantalite (LT), or lithium niobate (LN) other than the PZT. Elastic slip 102 has fixed end 102B fixed to fixing section 103 and free end 102A opposite to fixed end 102B and not fixed to fixing section 103. Power generating section 101 is disposed on fixed end 102B side. Vibration produces a distortion on elastic slip 102 while a larger distortion is produced at a position closer to the fixed end 102B than at a position closer to free end 102A. Power generating section 101 may preferably be disposed at a portion of elastic slip 102 including fixed end 102B, so that power generating element 101 can produce a large amount of electric power. Weight 104 attached to elastic slip 102 can control a frequency of the vibration and electric power of power generating element 101. Weight 104 is placed on elastic slip 102 at a position of elastic slip 102 closer to free end 102A than to fixed end 102B. Weight 104 may preferably be placed at a portion of elastic slip 102 including free end 102A, thereby increasing amplitude of vibration of elastic slip 102, accordingly increasing the electric power produced by power generating element 101.

Power generating section 101 or weight 104 can be disposed on a lower surface of elastic slip 102, or disposed on both of an upper surface and the lower surface of elastic slip 102. Weight 104 may not be necessarily provided.

Other than the piezoelectric power generating element, elements that can convert vibration, light, or heat energy into electric energy can be used as power generating element 101. These elements include an electret and a magnetic coil.

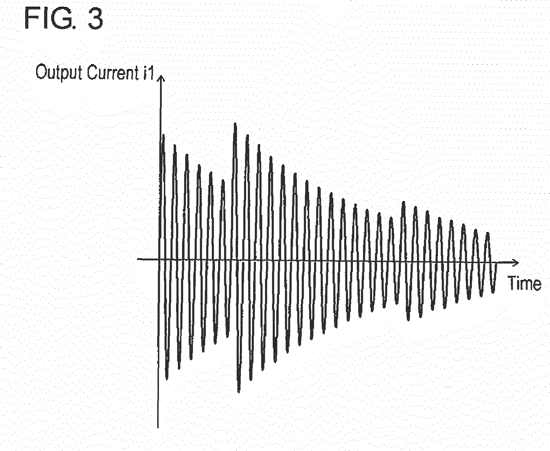

An operation of energy-harvesting device 1001 will be described below. FIG. 3 shows a waveform of output current i1 produced by vibrating power generating element 1. A vibration produced by flipping free end 102A of elastic slip 102, or a vibration produced at fixing section 103 and transmitting to elastic slip 102 via fixed end 102B blends elastic slip 102, thereby applying a mechanical distortion to piezoelectric layer 101B, which then generates alternately positive and negative electric charges in response to the direction of the applied distortion. Then, as shown in FIG. 3, output current i1 (AC) in response to the vibration of elastic slip 102 is produced across upper electrode 101C and lower electrode 101A. As illustrated as current i1 shown in FIG. 3, an external force is input three times to elastic slip 102 to produce large amplitude every time the external force is input. Current i1 is produced while elastic slip 102 repeats attenuating vibrations. A constant external force is seldom input, so that amplitudes upon receiving the external force are dispersed, hence outputting unstable current i1.

Rectifying circuit 2 converts AC output current i1 supplied from power generating element 1 into a DC current, and outputs output current i2L. Output current i2L is the sum of charging current i3C flowing to storage capacitor 3 and current i6 flowing to delay section 6. At this moment, DC/DC converter 4 is not activated, and does not allow current i4 to flow. Storage capacitor 3 is charged with current i3C. When DC/DC converter 4 is activated, discharge current i3D is supplied to DC/DC converter 4. Therefore, voltage Vin supplied to DC/DC converter 4 becomes equal to the charged voltage of storage capacitor 3.

On the other hand, current i6 flows into delay capacitor 6B via resistor 6A that is a structural element of delay section 6, thereby allowing delay capacitor 6B to store electric charges. The electric charges gradually produce a potential difference between delay capacitor 6B and the ground. In other words, the potential difference, namely, a voltage produced between delay capacitor 6B and the ground delays with respect to an input voltage applied to DC/DC converter 4. This potential difference is equal to an input voltage to controller 7. When the potential difference reaches a predetermined value, controller 7 outputs activating signal Sc that activates DC/DC converter 4. The time point at which the potential difference reaches the predetermined value is controlled by a time constant determined by resistor 6A and delay capacitor 6B. As discussed above, delay section 6 delays a voltage (a voltage across storage capacitor 3 per se in accordance with Embodiment 1) corresponding to the voltage across storage capacitor 3, and then outputs the delayed voltage.

For instance, in the case that controller 7 includes comparator 7A, comparator 7A compares reference voltage Vref connected to a noninverting input terminal of comparator 7A with an input voltage to comparator 7A, and outputs activating signal Sc based on the comparison result. To be more specific, when the input voltage to comparator 7A is higher than reference voltage Vref, comparator 7A of controller 7 outputs activating signal Sc that activates DC/DC converter 4. The reference voltage Vref is a predetermined constant voltage.

Controller 7 can be replaced with not only comparator 7A but also a circuit that can transmit a signal activating DC/DC converter 4. Controller 7 can be also built in DC/DC converter 4.

The timing at which activating signal Sc is output can be controlled according to a time constant determined by resistor 6A and delay capacitor 6B, hence disabling DC/DC converter 4 to be activated until predetermined electric power can be charged in storage capacitor 3.

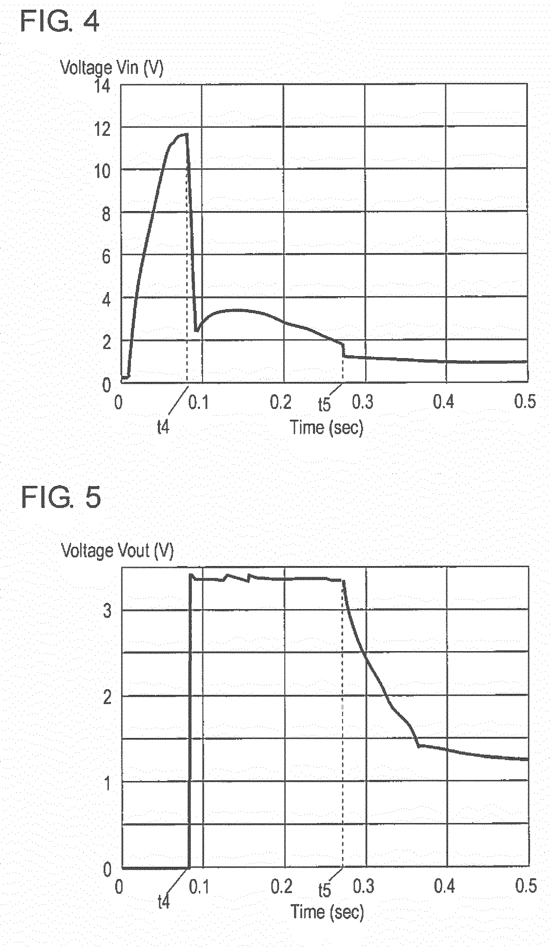

FIGS. 4 and 5 show input voltage Vin and output voltage Vout of DC/DC converter 4. When power generating element 1 generates current i1 shown in FIG. 3, rectifying circuit 2 rectifies current i1 and supplies charging current i3C to storage capacitor 3 for charging storage capacitor 3. Input voltage Vin of DC/DC converter 4 equal to the voltage across capacitor 3 rises from 0 (V) at time point 0 (sec) as shown in FIG. 4, while delay capacitor 6B is charged with current i6 flowing through resistor 6A of delay section 6. This charge disables DC/DC converter 4 to be activated until the voltage of delay capacitor 6B reaches reference voltage Vref of comparator 7A. In other words, as shown in FIG. 5, output voltage Vout of DC/DC converter 4 stays 0 (zero) until time point t4.

After time point t4, comparator 7A outputs activating signal Sc for activating DC/DC converter 4. DC/DC converter 4 then outputs voltage Vout for supplying predetermined given voltage, 3.4 (V) in this embodiment, to load 5.

Load 5 may preferably be connected in parallel to smoothing capacitor 5C for reducing ripples on the output voltage from DC/DC converter 4.

In the case that load 5 is a sensor sensing a physical quantity, such as a temperature, humidity, or acceleration, this sensor senses the physical quantity while the output voltage Vout stays at a predetermined voltage, and transmits, to an outside, a signal corresponding to the sensed physical quantity.

As shown in FIG. 3, an attenuation of the vibration amplitude of elastic slip 102 reduces current i1 proportionately thereto, and accordingly decreases charging current i3C to 0 (zero). Then, voltage Vin decreases accordingly. When voltage Vin decreasing becomes, at time point t5, lower than a voltage which can be converted by DC/DC converter 4, and prevents output voltage Vout from being kept at the predetermined voltage (3.4V) any longer, hence lowering output voltage Vout to 0 (zero).

In conventional energy-harvesting device 500 shown in FIG. 10, electric power charged in storage capacitor 503 is supplied to load 505; however, storage capacitor 503 can be charged only up to a voltage that can activate DC/DC converter 504. In order to increase electric power to be supplied to load 505, storage capacitor 503 having a large capacitance is used, or DC/DC converter 504 is redesigned such that converter 504 can be activated with another voltage. These changes increase the size or cost of the conventional energy-harvesting device.

In the case that conventional DC/DC converter 504 is a boost converter, a low input voltage Vin to converter 504 can activate converter 504; however, since the activation voltage is lower than a necessary boosting voltage, it is not enough to boost the voltage. Activated DC/DC converter 504 thus cannot charge storage capacitor 503 to a voltage capable of boosting, so that the electric power charged in storage capacitor 503 is output uselessly without boosting DC voltage Vout to a predetermined level.

The output voltage Vout of conventional DC/DC converter 504 for activating load 505 is 3.4 V. However, as shown in FIG. 11, in the case that DC/DC converter 504 is activated at 2V, when the voltage across storage capacitor 503 reaches 2V, DC/DC converter 504 is activated and output voltage Vout without being boosted. As a result, voltage Vout may be saturated at about 1 V, and does not reach a predetermined voltage, namely, 3.4V.

In the case that the input electric power is unstable, DC/DC converter 504 may be activated at time point t504 before storage capacitor 503 is fully charged in conventional energy-harvesting device 500. This disables storage capacitor 503 to fully store the electric power generated by power generating element 501, and the electric power bypasses capacitor 503 and flows to DC/DC converter 504 as it is. As a result, a sufficient amount of electric charges is not stored in capacitor 503, so that voltage Vin that is equal to the voltage across capacitor 503 and is supplied to converter 504 does not reach a voltage capable of boosting. Output voltage Vout is output from converter 504 before output voltage Vout reaches a predetermined level. Therefore, storage capacitor 503 cannot store predetermined electric power, and fails to efficiently supply electric power to load 505.

As discussed above, in energy-harvesting device 1001 in accordance with Embodiment 1, delay section 6 and controller 7 do not activate DC/DC converter 4 until storage capacitor 3 is fully charged even though the input power is unstable, so that DC/DC converter 4 can supply a predetermined voltage, namely, output voltage Vout necessary for activating load 5, thus supplying sufficient output power.

As shown in FIG. 1, current i6 is obtained from current i1 produced by power generating element 1, so that current i6 is not included in the output from energy-harvesting device 1001, and current i6 is regarded as a loss. According to Embodiment 1, the resistance of resistor 6A is changed into a large resistance, e.g. larger than 500 kΩ to reduce current i6 regarded as a loss. In this case, the capacitance of storage capacitor 6B is changed to satisfy the following condition:

$$(\text{resistance of resistor 6A before changing}) \times (\text{capacitance of delay capacitor 6B before changing}) = (\text{resistance of resistor 6A after changing}) \times (\text{capacitance of capacitor 6B after changing})$$

The resistance of resistor 6A and the capacitance of storage capacitor 6B are changed under the above condition to allow delay section 6 to have the same time constant before and after the change, thereby stopping DC/DC converter 4 until storage capacitor 3 is fully charged.

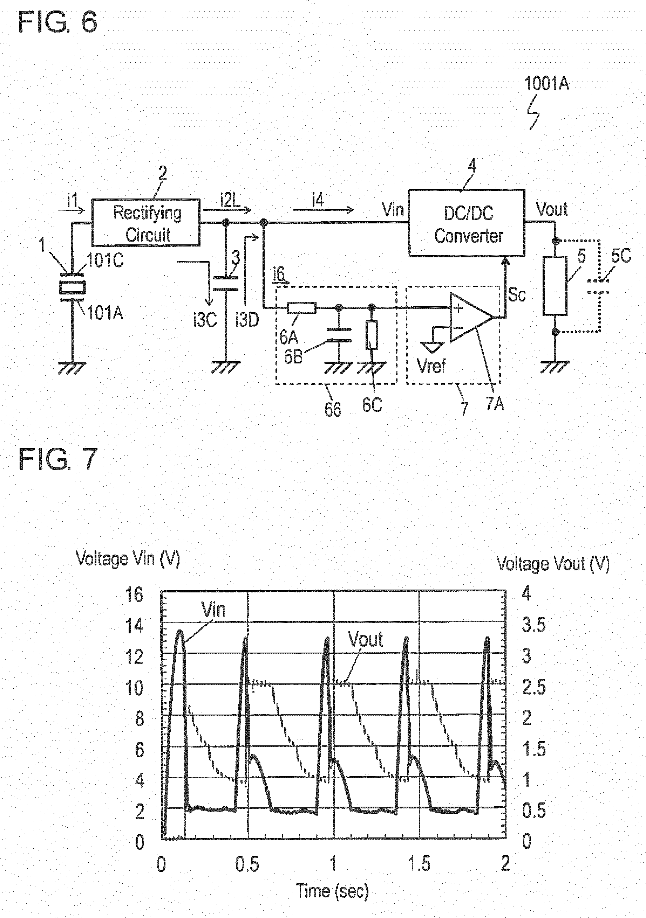

FIG. 6 is a circuit diagram of another energy-harvesting device 1001A in accordance with Embodiment 1. In FIG. 6, components identical to those of energy-harvesting device 1001 shown in FIG. 1 are denoted by the same reference numerals. Energy-harvesting device 1001A shown in FIG. 6 includes delay section 66 instead of delay section 6 of energy-harvesting device 1001 shown in FIG. 1. Delay section 66 is connected to rectifying circuit 2, storage capacitor 3, and an input terminal of DC/DC converter 4. A voltage corresponding to a voltage across storage capacitor 3 is applied to delay section 66. Delay section 66 further includes resistor 6C connected in parallel to delay capacitor 6B of delay section 6 shown in FIG. 1.

In energy-harvesting device 1001 shown in FIG. 1, when a voltage across delay capacitor 6B reaches reference voltage Vref of comparator 7A, the electric charges stored in capacitor 6B is discharged with a time constant determined by resistor 6A and delay capacitor 6B, so that unsteady attenuating inputs occur intermittently as shown in FIG. 3. If the attenuation speed of these inputs is larger than a speed necessary for discharging delay capacitor 6B to stop DC/DC converter 4, storage capacitor 3 may fail to store sufficient electric charges therein.

FIG. 7 shows input voltage Vin and output voltage Vout of DC/DC converter 4 of energy-harvesting device 1001A. In energy-harvesting device 1001A shown in FIG. 6, a discharge speed of delay capacitor 6B can be controlled with resistor 6C, so that DC/DC converter 4, namely, energy-harvesting device 1001A, can supply electric power (output voltage Vout) to load 5 intermittently.

EXEMPLARY EMBODIMENT 2

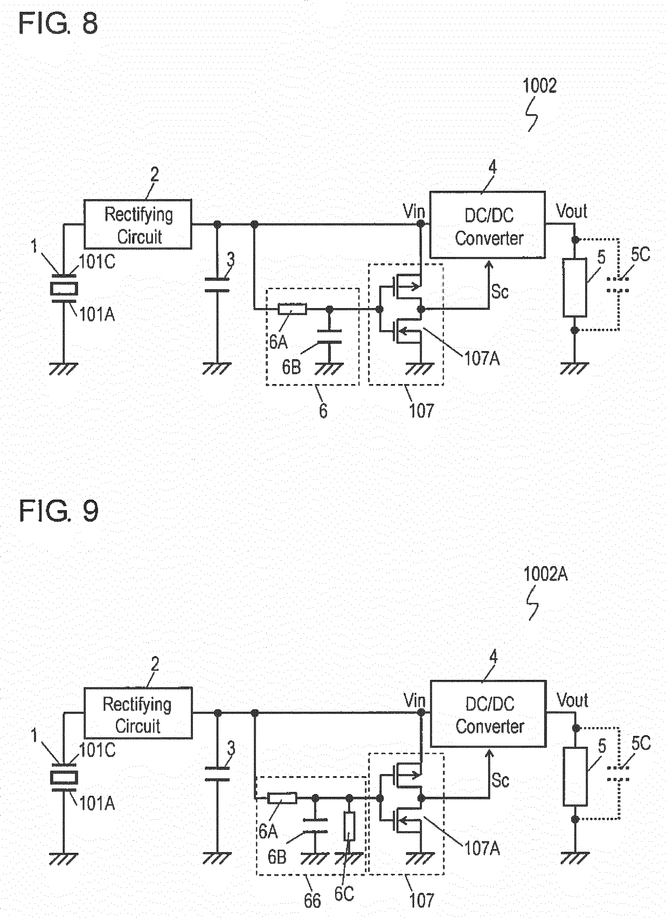

FIG. 8 is a circuit diagram of energy-harvesting device 1002 in accordance with Exemplary Embodiment 2. In FIG. 8, components identical to those of energy-harvesting device 1001 shown in FIG. 1 in accordance with Embodiment 1 are denoted by the same reference numerals. Energy-harvesting device 1002 includes controller 107 instead of controller 7 of energy-harvesting device 1001 shown in FIG. 1 in accordance with Embodiment 1.

Controller 107 includes CMOS inverter 107A that receives a voltage delayed by delay section 6 and then outputs activating signal Sc. To be more specific, while voltage Vin is applied, and when the voltage delayed by delay section 6 exceeds a threshold of CMOS inverter 107A, inverter 107A starts working. Inverter 107A can be designed such that the threshold can be independent of a voltage input to inverter 107A.

Similarly to energy-harvesting device 1001 shown in FIGs 1 to 5 in accordance with Embodiment 1, energy-harvesting device 1002 in accordance with Embodiment 2 disables DC/DC converter 4 to start working until storage capacitor 3 stores predetermined electric power. DC/DC converter 4 thus can output a predetermined output voltage Vout necessary for activating load 5.

Controller 107 may not necessarily include CMOS inverter 107A, but can include another circuit that can activate DC/DC converter 4.

FIG. 9 is a circuit diagram of another energy-harvesting device 1002A in accordance with Embodiment 2. In FIG. 9, components identical to those of energy-harvesting device 1002 shown in FIG. 8 are denoted by the same reference numerals. Energy-harvesting device 1002A shown in FIG. 9 includes delay section 66 instead of delay section 6 of energy-harvesting device 1002 shown in FIG. 8. Delay section 66 is identical to section 66 the same as one used in energy-harvesting device 1001A shown in FIG. 6 in accordance with Embodiment 1. Delay section 66 further includes resistor 6C connected in parallel to delay capacitor 6B of delay section 6 shown in FIG. 8.

In energy-harvesting device 1002 shown in FIG. 8, when a voltage across delay capacitor 6B reaches a threshold of CMOS inverter 107A, the electric charges stored in capacitor 6B is discharged with a time constant determined by resistor 6A and delay capacitor 6B, so that unsteady attenuating inputs may occur intermittently as shown in FIG. 3. In the case that the attenuation speed of these inputs is larger than a speed necessary for discharging delay capacitor 6B to stop DC/DC converter 4, storage capacitor 3 may fail to store sufficient electric charges therein.

In energy-harvesting device 1002A shown in FIG. 9, a discharge speed of delay capacitor 6B can be controlled with resistor 6C, so that, as shown in FIG. 7, DC/DC converter 4, namely, energy-harvesting device 1002A, can supply electric power (output voltage Vout) to load 5 intermittently as energy-harvesting device 1001A shown in FIG. 6 does.

INDUSTRIAL APPLICABILITY

An energy-harvesting device according to the present invention can output a necessary output voltage, so that it is useful for electronic devices that require maintenance-free performance.

REFERENCE MARKS IN DRAWINGS

| | |
|---|---|
| 1 | power generating element |
| 3 | storage capacitor |
| 4 | DC/DC converter |
| 6 | delay section |
| 6A | resistor (first resistor) |
| 6B | delay capacitor |
| 6C | resistor (second resistor) |
| 7 | controller |
| 7A | comparator |
| 66 | delay section |
| 107 | controller |
| 107A | CMOS inverter |
| Vref | reference voltage |

**Claims**

1.  An energy-harvesting device comprising:

    a power generating element configured to generate electric power;
    a storage capacitor configured to store the electric power generated by the power generating element;
    a DC/DC converter configured to convert, into a predetermined voltage, a voltage obtained from the electric power generated by the power generating element and the electric power stored in the storage capacitor;
    a delay section for delaying a voltage corresponding to a voltage across the storage capacitor; and
    a controller configured to output an activating signal that activates the DC/DC converter when the delayed voltage is higher than a reference voltage.

2.  The energy-harvesting device according to claim 1, wherein the delay section includes:

    a first resistor having a first end connected to the storage capacitor and a second end connected to the controller; and
    a delay capacitor connected between the second end of the first resistor and a ground.

3.  The energy-harvesting device according to claim 2, wherein the delay section further includes a second resistor

**EP 3 041 128 A1**

connected in parallel to the delay capacitor.

4. The energy-harvesting device according to any one of claims 1 to 3, wherein the controller includes a comparator configured to compare the delayed voltage with the reference voltage.

5. The energy-harvesting device according to any one of claims 1 to 4, wherein the reference voltage is a predetermined constant voltage.

6. The energy-harvesting device according to any one of claims 1 to 3, wherein the controller includes a CMOS inverter configured to receive the delayed voltage and to output the activating signal.

FIG. 1

FIG. 2

## FIG. 3

Output Current i1

Time

FIG. 4

Voltage Vin (V)

FIG. 5

Voltage Vout (V)

EP 3 041 128 A1

## FIG. 6

## FIG. 7

11

FIG. 8

FIG. 9

EP 3 041 128 A1

FIG. 10

500

502                    504
Rectifying    Vin    DC/DC    Vout
Circuit              Converter

501                              505
        503

FIG. 11

Voltage (V)
2.5

2                                          Vin

1.5

                                           Vout
1

0.5

0
  0    0.05   0.1   0.15   0.2   0.25
     t504              Time (sec)

13

## INTERNATIONAL SEARCH REPORT

| | International application No. |
|---|---|
| | PCT/JP2014/003792 |

**A. CLASSIFICATION OF SUBJECT MATTER**
*H02N2/18*(2006.01)i

According to International Patent Classification (IPC) or to both national classification and IPC

**B. FIELDS SEARCHED**

Minimum documentation searched (classification system followed by classification symbols)
H02N2/18

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2006-56501 A (Societe de Technologie Michelin), 02 March 2006 (02.03.2006), paragraph [0030]; fig. 6 & US 2005/0285728 A1 & EP 1612059 A1 & CN 1716748 A | 1-6 |
| Y | JP 10-105259 A (Nemic Lambda Kabushiki Kaisha), 24 April 1998 (24.04.1998), paragraph [0004]; fig. 2 (Family: none) | 1-6 |
| Y | JP 9-308235 A (Hioki E.E. Corp.), 28 November 1997 (28.11.1997), paragraphs [0021] to [0023], [0027] to [0029]; fig. 1 to 2 (Family: none) | 1-6 |

☒ Further documents are listed in the continuation of Box C.     ☐ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 11 September, 2014 (11.09.14) | 22 September, 2014 (22.09.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/003792

| C (Continuation). | DOCUMENTS CONSIDERED TO BE RELEVANT | |
|---|---|---|
| Category* | Citation of document, with indication, where appropriate, of the relevant passages | Relevant to claim No. |
| Y | Microfilm of the specification and drawings annexed to the request of Japanese Utility Model Application No. 186577/1986(Laid-open No. 90984/1988)<br>(NEC Corp.),<br>13 June 1988 (13.06.1988),<br>specification, page 9, line 8 to specification, page 10, line 7; fig. 1<br>(Family: none) | 1-6 |
| A | JP 2008-125180 A  (Denso Corp.),<br>29 May 2008 (29.05.2008),<br>paragraphs [0047] to [0049]; fig. 1 to 2<br>& US 2008/0111594 A1    & DE 102007050844 A1<br>& FR 2908943 A1 | 1-6 |
| A | JP 54-148219 A  (Toko, Inc.),<br>20 November 1979 (20.11.1979),<br>entire text<br>(Family: none) | 1-6 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012080596 A